# EUROPEAN PATENT SPECIFICATION

(11) **EP 4 290 258 B1**
(45) Date of publication and mention of the grant of the patent: **07.08.2024**
(21) Application number: 22178260.0
(22) Date of filing: 09.06.2022
(51) Int. Cl.: G01R 31/42, G01R 31/28

(54) **ELECTRICAL LOAD EMULATOR FOR AN INVERTER UNDER TEST**
ELEKTRISCHER LASTEMULATOR FÜR EINEN ZU PRÜFENDEN WECHSELRICHTER
ÉMULATEUR DE CHARGE ÉLECTRIQUE POUR UN ONDULEUR EN COURS DE TEST

(43) Date of publication of application: 13.12.2023
(73) Proprietor: Leadrive Technology Germany GmbH, 52074 Aachen (DE)
(72) Inventor: PAN, Xuanlin, 52074 Aachen (DE); REISNER, Marcel, 52074 Aachen (DE); SCHUBERT, Michael, 52074 Aachen (DE)
(74) Representative: Ridderbusch, Oliver

(56) References cited:
- US-A1- 2021 036 646
- WANG MING-YU ET AL: "A Desktop Electric Machine Emulator Implementation Method Based on Phase Voltage Reconstruction", IEEE ACCESS, IEEE, USA, vol. 8, 23 May 2020 (2020-05-23), pages 97698 - 97706, XP011791388, DOI: 10.1109/ACCESS.2020.2997388
- XIE YUANHAO ET AL: "Improved Accuracy of Power Electronic-Based Motor Emulation With Compensation for Signal Transmission Delay", IEEE TRANSACTIONS ON TRANSPORTATION ELECTRIFICATION, IEEE, vol. 8, no. 1, 29 September 2021 (2021-09-29), pages 886 - 897, XP011903568, DOI: 10.1109/TTE.2021.3116660

## Description

### Field of the invention

The present disclosure relates to an electrical load emulator for an inverter under test.

### Description of prior art

Inverters are widely used to drive electrical loads such as electrical motors or power networks. To test an inverter under test (IUT), there are generally two options. The first option consists in using a test bench comprising an electrical load. For example, in the case of an inverter configured to drive a motor, the test bench is a motor test bench comprising a matched motor and a load motor coupled to the matched motor. During the tests, the inverter is connected to its matched motor, and the matched motor is coupled to the load motor which can provide required torque load and absorb the mechanical power generated by the matched motor. This setup can test the inverter in almost real use cases, but it is expensive, inflexible, and time-consuming for testing different inverters and motors.

The second option is to test the inverter using an electrical load emulator (ELE). For example, the ELE can be a motor emulator which can emulate the electrical behavior of a real motor. This test method belongs to the category of Power Hardware-in-the-Loop Test (PHiL). For example, some advantages of a motor emulator are:
- Flexibility: for a motor test bench, the test setup should be changed and calibrated every time before a new motor is applied. This is a big problem because an inverter manufacturer usually builds inverters for tens of different motors. In contrast, the motor emulator can emulate almost all kinds of motors using the same hardware setup. To test a new motor, only slight change is necessary in the software of the motor emulator.
- Safety: since a motor emulator does not have any mechanical parts, there is no kinetic energy or vibration while testing. Therefore, the test with a motor emulator is safer compared to a motor test bench. Meanwhile, fault cases can be tested non-destructively.

- Acceleration of the design process: a motor emulator can largely accelerate the design process of the drivetrain, especially for global cooperation. For example, if a motor manufacturer in Europe plans to integrates an inverter into the drivetrain, a test sample of motor or inverter may have to be sent by a provider for building the motor test bench. The motor should be already completely designed and manufactured. While using a motor emulator, the motor manufacturer only needs to send out the detailed motor data. The test bench using a motor emulator can start operation within an hour and send back the test results in the same day. Therefore, the drivetrain can already be tested in the design phase of a motor, which in turn helps design the motor dedicated for the drivetrain.

Electrical load emulator systems already exist and are commercially available. Document US2021/0036646 A1 discloses embodiments relating to a motor emulator for an inverter under test (IUT), the motor emulator comprising: a voltage follower inverter for at least partially cancelling an output voltage of the IUT; and an output current control unit for controlling an output current of the IUT on the basis of an estimated current of a simulation target motor.

WANG MING-YU ET AL: "A Desktop Electric Machine Emulator Implementation Method Based on Phase Voltage Reconstruction", IEEE ACCESS, IEEE, USA, vol. 8, 23 May 2020, pages 97698-97706, XP011791388, DOI: 10.1109/ACCESS.2020.2997388 and XIE YUANHAO ET AL: "Improved Accuracy of Power Electronic-Based Motor Emulation With Compensation for Signal Transmission Delay", IEEE TRANSACTIONS ON TRANSPORTATION ELECTRIFICATION, IEEE, vol. 8, no. 1, 29 September 2021, pages 886-897, XP011903568, DOI: 10.1109/TTE.2021.3116660 also disclose similar systems.

Despite their advantages, most of the known ELE involve complex control strategies, complex filter architectures, or galvanically isolated supply. This results in more complex hardware topology, higher costs and weight, and reduced portability of the ELE. This is especially the case of ELE suitable for emulating a dynamical operation of electrical loads i.e., for emulating the power transients of the load between different operating points.

There is a need for an ELE suitable for a dynamical emulation of electrical loads and with reduced complexity and cost. The present invention concerns a low-cost ELE which can be built with standard and reduced number of components, while enabling the emulation of load transients.

### Summary of the invention

The invention is defined by the independent claims. The dependent claims define advantageous embodiments.

According to the invention, there is provided an electrical load emulator (ELE) for an inverter under test (IUT), wherein an IUT output voltage V_{IUT} at an IUT output terminal is configured to take a plurality of IUT voltage states, separated by IUT rising and falling edges, and wherein an ELE output voltage at an ELE output terminal is configured to take a plurality of ELE voltage states, separated by ELE rising and falling edges, and wherein to each IUT voltage state corresponds at least one ELE voltage state. The ELE comprises a current sensor configured to measure an IUT output current I_{IUT}, a coupling filter for connecting the ELE to the IUT, and a voltage sensing unit configured for sensing the IUT output voltage V_{IUT}. The ELE also comprises a control unit configured to determine a reference current I_{REF} corresponding to an emulated electrical load based on the sensed IUT output voltage V_{IUT}, and to compare the reference current I_{REF} to the measured IUT output current I_{IUT}, wherein:
- if I_{REF} is substantially equal to I_{IUT}, the control unit is configured to control the ELE output voltage to synchronously follow the IUT output voltage, such that each of the IUT rising and/or falling edge between two subsequent IUT voltage states is followed by a corresponding ELE rising and/or falling edge between two subsequent ELE voltage states, respectively,
- if I_{REF} is higher than I_{IUT}, the control unit is configured to delay the following ELE rising edge with respect to its corresponding IUT rising edge by a rising edge time delay,
- if I_{REF} is lower than I_{IUT}, the control unit is configured to delay the following ELE falling edge with respect to its corresponding IUT falling edge by a falling edge time delay.

Preferably, each phase of the coupling filter of the ELE according to the invention may comprise at least a series-connected inductor L_{F}, preferably only the series-connected inductor L_{F}.

Preferably, the ELE inverter of the ELE according to the invention has a two-level topology or multi-level topology.

Preferably, the ELE inverter of the ELE according to the invention is configured to be supplied by a DC power source which is shared with the IUT.

Preferably, the control unit of the ELE according to the invention is configured to:
- determine the reference current I_{REF} corresponding to the emulated electrical load based on the measured IUT output voltage V_{IUT},
- compare the reference current I_{REF} to the measured IUT output current I_{IUT}, and calculate the rising or falling edge time delay,
asynchronously with the IUT output voltage V_{IUT}.

Preferably, the control unit is configured to:
- determine the reference current I_{REF} corresponding to the emulated electrical load based on the measured IUT output voltage V_{IUT} periodically at a second frequency F2, wherein the second frequency F2 is preferably comprised between a third of the switching frequency of the IUT and 300 MHz, preferably between the switching frequency of the IUT and 100 MHz, preferably between 2 and 50 MHz, preferably between 3 and 10 MHz.
- compare the reference current I_{REF} to the measured IUT output current I_{IUT} and calculate the rising or falling edge time delay periodically and at a third frequency F3, wherein the third frequency F3 is preferably lower than or equal to the second frequency F2, and wherein the third frequency F3 is preferably comprised between 100 Hz and 100 MHz, preferably between 1 kHz and 20 MHz, preferably between 10 kHz and 10 MHz, preferably between 1 and 5 MHz.

According to the invention, there is provided a method for controlling an electrical load emulator (ELE) for testing an inverter under test (IUT) wherein an IUT output voltage V_{IUT} at an IUT output terminal is configured to take a plurality of IUT voltage states, separated by IUT rising and falling edges, the method comprising :
- sensing the IUT output voltage V_{IUT} at the IUT output terminal,
- determining a reference current I_{REF} corresponding to an emulated electrical load based on the sensed IUT output voltage V_{IUT},
- measuring an IUT output current I_{IUT},
- comparing the reference current I_{REF} to the measured IUT output current I_{IUT},
- if I_{REF} is substantially equal to I_{IUT}, controlling the ELE output voltage to synchronously follow the IUT output voltage V_{IUT}, such that each IUT rising and/or falling edge between two subsequent IUT voltage states is followed by a corresponding ELE rising and/or falling edge between two subsequent ELE voltage states, respectively,
- if I_{REF} is higher than I_{IUT}, delaying the following ELE rising edge with respect to its corresponding IUT rising edge by a rising edge time delay,
- if I_{REF} is lower than I_{IUT}, delaying the following ELE falling edge with respect to its corresponding IUT falling edge by a falling edge time delay.

According to the invention, there is also provided a programmable hardware for controlling an electrical load emulator (ELE) for testing an inverter under test (IUT) configured for making an ELE perform the method according to the invention, wherein the programmable hardware is a programmable logic device such as FPGA, EPROM, or a microcontroller.

### Short description of the drawings

These and other features, aspects, and advantages of the apparatus, systems and methods of the present disclosure will become better understood from the following description, appended claims, and accompanying drawing wherein:
- Fig. 1: represents schematically a system comprising an ELE according to the invention and an IUT, wherein electrical power connections are represented by continuous lines, and control signal connections are represented by dashed lines.
- Fig. 2: represents schematically a three phase ELE inverter connected to a three phase IUT through a coupling filter.
- Fig. 3: represents schematically a single phase of a coupling filter connected to an IUT and an ELE and comprising only series-connected elements.
- Fig. 4: is a graph of the IUT and ELE output variables and of the reference current I_{REF} as a function of time, when I_{REF} is substantially equal to I_{IUT}.
- Fig. 5: is a graph of the IUT and ELE output variables and of the reference current I_{REF} as a function of time, when I_{REF} is higher than I_{IUT}.
- Fig. 6: is a graph of the IUT and ELE output variables and of the reference current I_{REF} as a function of time, when I_{REF} is lower than I_{IUT}.

The drawings of the figures are neither drawn to scale nor proportioned. Generally, identical components are denoted by the same reference numerals in the figures.

### Detailed description of embodiments of the invention

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes.

Where the term "comprising" is used in the present description and claims, it does not exclude other elements or steps.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

The terms "about" or "approximate" and the like are synonymous and are used to indicate that the value modified by the term has an understood range associated with it, where the range can be +20%, +15%, +10%, +5%, or +1%. The term "substantially" is used to indicate that a result (e.g., measurement value) is close to a targeted value, where close can mean, for example, the result is within 80% of the value, within 90% of the value, within 95% of the value, or within 99% of the value. Substantially equal values can be understood as values that differ at most by 20%, or 10%, or 5% or 1% from each other.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

### Electrical Load Emulator (ELE)

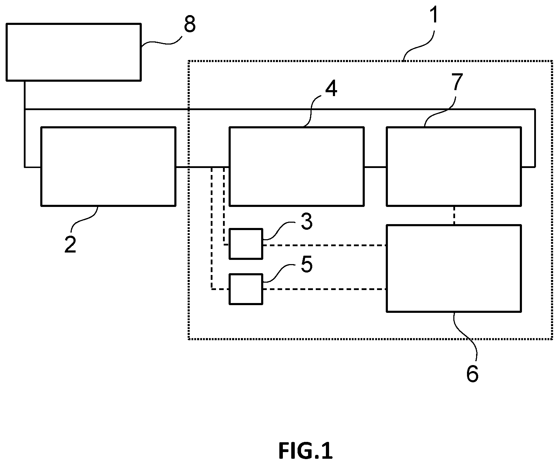

Fig. 1 represents an example of an electrical load emulator (1) according to the invention herein referred to as an ELE, which is coupled to an inverter under test (2) herein referred to as an IUT. The ELE (1) comprises an ELE inverter (7) and a coupling filter (4) configured to connect the ELE inverter (7) to the IUT (2).

As represented in Fig. 1, a DC power source (8) is connected to and supplies electrical power to the IUT (2). In an example of the invention represented in Fig. 1, the ELE (1) is configured to share the DC power source (8) with the IUT (2). In this case, the DC power source (8) can be downsized because it should only provide the combined losses of the ELE (1) and IUT (2), which is generally much lower than the peak power of the IUT (1) and of the ELE (2) considered separately. In another example, the ELE (1) according to the invention can be configured to connect to an ELE DC power source which is separate from the DC power source (8) supplying power to the IUT.

### Current sensor

As represented in Fig. 1, the ELE according to the invention comprises a current sensor (3) configured to measure an IUT output current I_{IUT} exiting an IUT output terminal, and to generate a current sensor output signal representative of the measured IUT output current I_{IUT}. For example, the current sensor (3) can be installed at the IUT output terminal or built-in in the ELE inverter (7).

### Voltage sensing unit

The ELE comprises a voltage sensing unit (5) configured to sense an IUT output voltage V_{IUT} at the IUT output terminal, and to generate a voltage sensing unit output signal representative of the sensed IUT output voltage V_{IUT}.

For example, the voltage sensing unit (5) can comprise a voltage comparator coupled or connected to the IUT output terminal, and the voltage sensing unit output signal is representative of a comparison between the IUT output voltage V_{IUT} and a given threshold. In this example, the ELE (1) is configured to determine an estimated IUT output voltage based at least on the voltage sensing unit output signal from the voltage comparator. Preferably, the ELE (1) is configured to determine an estimated IUT output voltage based on the voltage sensing unit output signal in combination with the current sensor output signal representative of the measured IUT output current I_{IUT}. This allows a more accurate IUT output voltage determination by the ELE (1) since the ELE can be configured to determine the IUT output voltage V_{IUT} based also on the voltage drop of conducting IUT IGBTs, for example, and on the forward voltage of antiparallel diode of the IUT IGBTs, for example. Preferably, the ELE (1) is configured to determine an estimated IUT output voltage V_{IUT} periodically, at a first frequency F1.

In another example, the voltage sensing unit (5) can comprise a voltage measurement sensor configured to measure an amplitude of the IUT output voltage V_{IUT}, and the voltage sensing unit output signal is representative of V_{IUT}. In another example, the voltage sensing unit (5) can comprise an edge detector, preferably an analog edge detector, configured for operating continuously and for detecting rising and falling edges of the IUT output voltage V_{IUT}.

The ELE (1) also comprises a control unit (6) connected to the ELE inverter (7) and to the current sensor (3) and voltage sensing unit (5). The control unit (6) is configured to receive the current sensor output signal and the voltage sensing unit output signal, and for controlling the ELE inverter (7) based on the measured IUT output current I_{IUT} and sensed IUT output voltage V_{IUT}, i.e., based on the voltage sensing unit output signal and on the current sensor output signal.

### Inverter Under Test (IUT)

The ELE (1) is configured to emulate a load of an IUT wherein an IUT output voltage V_{IUT} at an IUT output terminal (10) is a switched output voltage i.e., takes a plurality of IUT voltage states separated by IUT rising edges and IUT falling edges. The IUT falling and rising edges correspond to IUT output voltage transients caused by a change in states of IUT switches i.e., IUT switches shifting from an open position to a closed position or vice versa.

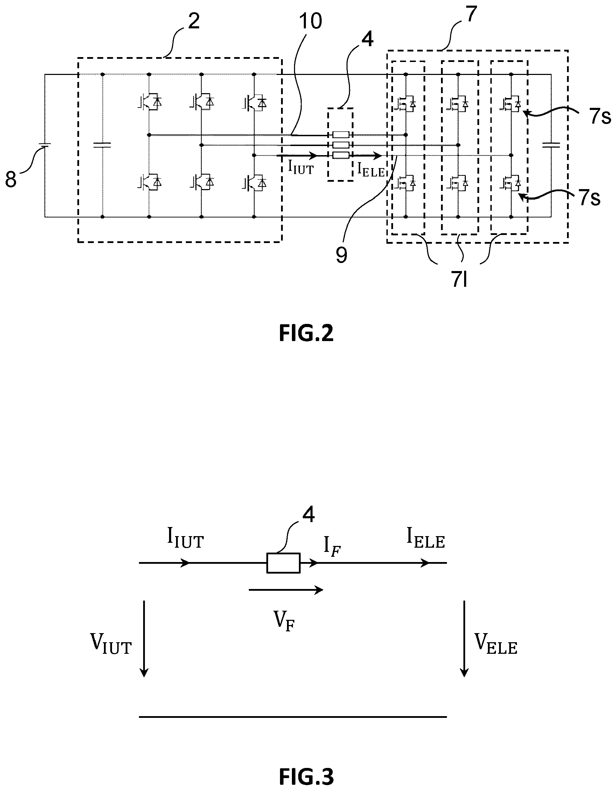

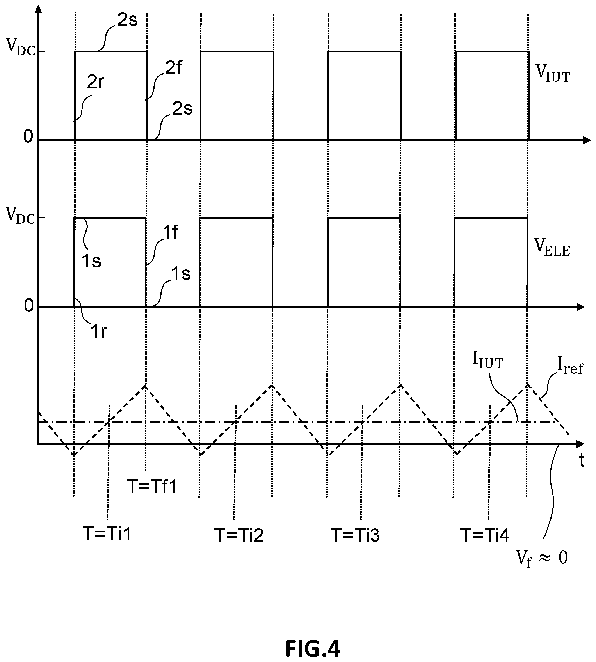

Fig. 4 shows an example of the evolution of the IUT output voltage V_{IUT} as a function of time. The V_{IUT} represented in Fig. 4 can be generated by a phase leg of a two-level inverter as represented in Fig. 2. In Fig. 4, there are a first and a second IUT voltage states (2s) corresponding to time intervals wherein the IUT output voltage is generally constant. An amplitude of a first IUT voltage state is null, whereas an amplitude of a second IUT voltage state is equal to a DC power source output voltage under which the DC power source (8) supplies power to the IUT (2). Generally speaking, the first IUT voltage state can be at DC-or low potential, and the second IUT voltage state can be at a DC+ or high potential. IUT voltage states (2s) are separated by IUT rising edges (2r) and IUT falling edges (2f). Of course, the skilled person shall easily recognize that the voltage and current signals represented in Fig. 4 are idealized signals which do not restrict the scope of the invention. In real cases, these signals comprising V_{IUT} and V_{ELE} can comprise noise, ripple, and the IUT and ELE rising and falling edges have finite slopes, which is not represented in Fig. 4. Parasitic delays are also not represented in Fig. 4. V_{IUT} can also comprise more than two IUT voltage states, for example if the IUT has a multilevel topology. For example, the IUT can have a neutral point clamped topology wherein the IUT output voltage V_{IUT} switches between a DC- voltage potential, a zero-voltage potential, and a DC+ voltage potential. As represented in Fig. 2, the IUT can be a multiphase IUT comprising a plurality of IUT inverter phase legs each providing an IUT output voltage at respective IUT output terminals (10) connected thereto.

The switched output voltage of the IUT may comprise the following modulation, PWM such as variable switching frequency PWM, or direct torque control.

### ELE inverter (7)

The ELE (1) according to the invention comprises an ELE inverter (7). This ELE inverter (7) comprises at least one ELE inverter phase leg (7l) comprising a number of switching units (7s). It can have one, two, three, four, or more ELE inverter phase legs. Fig. 2 represents an example of the ELE inverter (7) according to the invention and comprising three two-level ELE inverter phase legs (7l) each comprising two ELE switching units (7s), wherein ELE inverter phase leg central nodes are connected to respective ELE output terminals (9). The ELE output terminals (9) are configured to connect the ELE inverter (7) to the coupling filter (4). The ELE inverter (7) can also be a multilevel inverter for providing more than two voltage levels of the ELE output voltage V_{ELE}.

The ELE (1) is configured to command the ELE switching units (7s) to supply an ELE output voltage V_{ELE} at each of the ELE output terminal (9) which takes a plurality of ELE voltage states (1s), i.e. ELE voltage levels, separated in time by ELE rising edges (1r) and ELE falling edges (1f). The ELE output voltage V_{ELE} is thus a switched output voltage. The ELE falling and rising edges correspond to ELE output voltage transients following a change in a state of the switches of the ELE inverter, and the ELE voltage states correspond to a given state of the ELE switching units (7s).

In Fig. 4, an example of ELE output voltage V_{ELE} as a function of time is represented. It is a two-level voltage at one of the terminals (9) of the ELE. As with the IUT (2), the skilled person shall easily recognize that the ELE output voltage V_{ELE} represented in Fig. 4 is an idealized signal which shall not restrict the scope of the invention. The noise, ripple and other parasitic signal components which can be present in V_{ELE} are not represented. The ELE rising edges (1r) and falling edges (1f) have finite slopes, which is not represented in Fig. 4. V_{ELE} can also comprise more than two ELE voltage states, for example if the ELE inverter (7) has a multilevel topology.

### ELE and IUT voltage states

The ELE (1) is configured to supply the ELE output voltage V_{ELE} wherein to each IUT voltage state (2s) corresponds one ELE voltage state (1s) of substantially equal voltage such that a voltage across a coupling filter (4) connecting the ELE output terminals (9) to the IUT output terminals (10) can be substantially cancelled. Preferably, the ELE (1) is configured to supply the ELE output voltage V_{ELE} wherein a number of different ELE voltage states is identical to the number of different IUT voltage states.

The ELE (1) can comprise a multilevel ELE inverter which is suitable for supplying a higher number of distinct or different ELE voltage states (1s) than the number of distinct or different IUT voltage states (2s). In this case, the ELE (1) can be configured to command the switching units (7s) to supply only a reduced number of the ELE voltage states (1s), wherein each ELE voltage state of the reduced number of the ELE voltage states is substantially equal to one of the different IUT voltage states (2s).

### Coupling filter (4)

As shown in Fig. 2 and 3, the ELE (1) comprises a coupling filter (4) connecting the ELE output terminals (9) to the IUT output terminals (10). The coupling filter (4) of the ELE according to the invention can comprise one or more phases with preferably no cross coupling between the phases. Each phase of the coupling filter (4) comprises at least a series-connected inductor L_{F}, and preferably only the series-connected inductor L_{F}. Preferably, each phase of the coupling filter (4) comprises only series-connected elements as shown in Fig. 3, such that a filter current I_{F} traversing the coupling filter equals an IUT output current I_{IUT} exiting the IUT output terminal (10) and an ELE output current I_{ELE} entering the ELE output terminal (9).

### Control unit (6)

The control unit (6) in the ELE (1) is configured to determine a reference current I_{REF} corresponding to an emulated electrical load based on the voltage sensing unit output signal representative of the measured IUT output voltage V_{IUT}. For example, the emulated electrical load can be a motor or an electrical power network. The ELE (1) can comprise a model of the emulated electrical load, for example a motor model for determining a phase current of the emulated motor as a function of the phase voltage of the emulated motor. In this case, the phase current of the emulated motor is the calculated reference current I_{REF}, and the phase voltage of the emulated motor is the measured IUT output voltage V_{IUT}. Preferably, the control unit (6) in the ELE (1) is configured to determine the reference current I_{REF} periodically at a second frequency F2. Preferably, the second frequency F2 is equal to the first frequency F1. Preferably, the second frequency F2 is comprised between a third of the switching frequency of the IUT and 300 MHz, preferably between the switching frequency of the IUT and 100 MHz, preferably between 2 and 50 MHz, preferably between 3 and 10 MHz.

In an example of the ELE according to the invention, the control unit (6) comprises a discrete-time computing circuit configured for receiving the voltage sensing unit output signal and for determining the reference current I_{REF} periodically and at the second frequency F2. In the ELE according to the invention, this can be achieved asynchronously with the changes in the IUT voltage states at the IUT output terminal.

The paper IEEE TRANSACTIONS ON POWER ELECTRONICS, VOL. 33, NO. 8, AUGUST 2018, pp.6926-6935 (Digital Object Identifier 10.1109/TPEL.2017.2759662) describes examples of voltage sensing techniques which can be implemented for the sensing of the IUT output voltage U_{IUT} in the present invention.

The control unit (6) in the ELE (1) is also configured to compare the reference current I_{REF} to the measured IUT output current I_{IUT}, preferably periodically and at a third frequency F3. Preferably, the control unit (6) is configured for comparing a most recent value of the reference current I_{REF} determined by the control unit (6) to an instantaneous value of the IUT output current I_{IUT} measured by the current sensor (3). Preferably, the third frequency F3 is lower than or equal to the second frequency F2. Preferably, the third frequency F3 is comprised between 100 Hz and 100 MHz, preferably between 1 kHz and 20 MHz, preferably between 10 kHz and 10 MHz, preferably between 1 MHz and 5 MHz. Preferably, the third frequency F3 is higher than the switching frequency of the IUT or than a frequency at which an IUT output current target is refreshed by the IUT.

### I_{REF} substantially equal to I_{IUT}

If I_{REF} is substantially equal to I_{IUT}, the control unit (6) is configured to enter a voltage following mode i.e., to control the ELE output voltage V_{ELE} to synchronously follow the IUT output voltage V_{IUT}, such that each IUT rising and/or falling edge between two subsequent IUT voltage states is followed by a corresponding ELE rising and/or falling edge between two subsequent ELE voltage states, respectively. Fig. 4 illustrates an example of this operating mode of the ELE. In this example, the IUT output current I_{IUT} is measured by the current sensor (3) and compared to the reference current I_{REF} calculated by the control unit (6) at time instants Ti1, Ti2, Ti3, Ti4. In this case, I_{REF} is substantially equal to I_{IUT}, and the control unit (6) is configured to command the ELE switching units (7s) of the ELE inverter (7) to synchronously follow the IUT output voltage with the ELE output voltage i.e., the ELE (1) is configured to set the ELE output voltage V_{ELE} in an ELE voltage state which is substantially equal to the ongoing IUT voltage state at every time instant. In other words, the ELE is configured to follow the IUT output voltage V_{IUT} with the ELE output voltage V_{ELE} by synchronously setting V_{ELE} in one of the ELE voltage states which is substantially equal to an ongoing IUT voltage state. This is illustrated in Fig. 4 wherein, at time instant Tf1, V_{IUT} switches from a high to a low IUT voltage state which is detected by the voltage sensing unit of the ELE, and the ELE is configured to synchronously switch from a corresponding high ELE voltage state to a corresponding low ELE voltage state, respectively, wherein the high and low ELE voltage states are substantially equal to their corresponding high and low IUT voltage states.

If I_{REF} is substantially equal to I_{IUT}, the control unit (6) is configured to control the ELE voltage states taken by V_{ELE} to synchronously follows the IUT voltage state taken by V_{IUT}. In this case, each IUT voltage state and its synchronously following ELE voltage state are denoted as 'corresponding'. Similarly, if I_{REF} is substantially equal to I_{IUT}, the control unit (6) is configured to control the ELE rising and falling edges taken by V_{ELE} to synchronously follows the IUT rising and falling edges taken by V_{IUT}, respectively. In this case, each IUT rising or falling edge and its synchronously following ELE rising of falling edge are denoted as 'corresponding'.

Fig. 3 represents a single phase of the coupling filter connected to a phase of the IUT and a phase of the ELE. When I_{REF} is substantially equal to I_{IUT}, the ELE voltage states taken by V_{ELE} synchronously follow the IUT voltage state taken by V_{IUT}. This results in V_{IUT} ≈ V_{ELE} and the filter voltage V_{F} = V_{IUT} - V_{ELE} is substantially cancelled at substantially all time, and the filter current I_{F} remains substantially constant. In an example of the invention, the coupling filter (4) comprises only a series-connected inductor L_{F}, wherein a parasitic resistance R_{P} of the inductor L_{F} is preferably negligible. In this case, V_{F} = R_{P}*I_{IUT} + L_{F}*dI_{IUT}/dt ≈ L_{F}*dI_{IUT}/dt ≈ 0, and thus dI_{IUT}/dt = 0.

### Discrete and continuous operation of the control unit

To minimize parasitic time delays between the IUT and ELE rising edges when the ELE is in the voltage following mode, the control unit (6) can comprise a continuous-time logic unit configured for receiving the voltage sensing unit output signal, wherein the voltage sensing unit output signal is a continuous edge detection signal representative of the IUT rising and falling edges detection by the voltage sensing unit (5), for example. The continuous-time logic unit can be configured to control the ELE inverter and the ELE output voltage V_{ELE} to synchronously follow the IUT output voltage V_{IUT} based on the continuous edge detection signal. For example, the continuous-time logic unit can be an analog circuit operating continuously in time such as an EPROM or FPGA, and the voltage sensing unit output signal can be generated by a comparator comprised in the sensing unit which operates also continuously in time. The use of the continuous-time logic circuit combined with a comparator allows to minimize parasitic delays associated with sensing and control in the ELE compared with using discrete-time control circuit, for example.

Generally speaking, edges detection is much faster than actual voltage amplitude determination or measurement, and the control of the ELE inverter (7) to copy the IUT output signal based on edge detection signals is much faster than based on voltage amplitude measurement values.

For example, the ELE according to the invention can comprise the continuous-time logic circuit for following or copying the IUT output signal fastly, in combination with the discrete-time control circuit with slower reaction which is configured for determining the reference current I_{REF}.

### I_{REF} higher than I_{IUT}

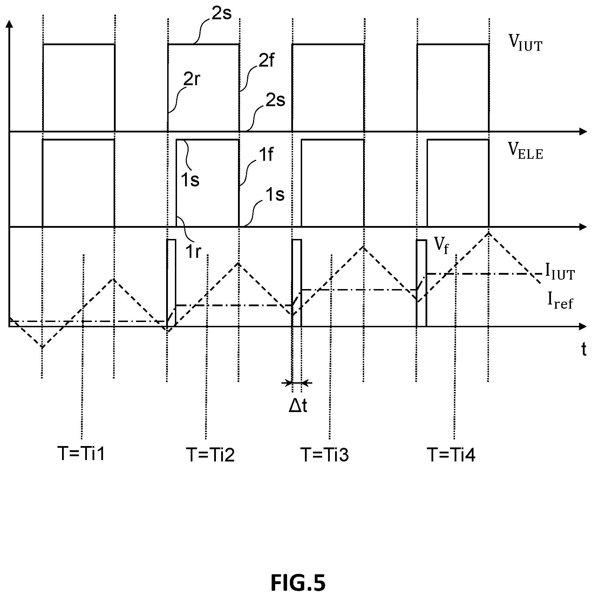

If I_{REF} is higher than I_{IUT}, the control unit (6) is configured to delay one of the following ELE rising edge (1r) with respect to its corresponding IUT rising edge (2r) by a rising edge time delay, as illustrated in Fig. 5. In the present context, the following ELE rising edges are the ELE rising edges occurring after the measured IUT output current is compared with the reference current and a rising edge time delay to be applied is calculated by the control unit (6). Preferably, the ELE (1) is configured to compare the reference current I_{REF} to the measured IUT output current I_{IUT} and to calculate the rising or falling edge time delay periodically at the third frequency F3. In the example of Fig. 5, the control unit (6) compares I_{REF} to I_{IUT} and calculates the rising edge time delay to be applied at the times Ti1, Ti2, Ti3, Ti4. Preferably, the control unit (6) is configured to delay the firstly occurring ELE rising edge (1r) with respect to its corresponding IUT rising edge (2r), as illustrated in Fig. 5, so that the IUT output current is rapidly adjusted closer to the reference current. Of course, the skilled person shall easily recognize that the voltage and current signals represented in Fig. 5 are idealized signals which do not restrict the scope of the invention. In real cases, these signals comprising V_{IUT} and V_{ELE} can comprise noise, ripple, and the IUT and ELE rising and falling edges have finite slopes, which is not represented in Fig. 5. Parasitic delays are also not represented in Fig. 5.

If I_{REF} is higher than I_{IUT}, the control unit (6) is thus preferably configured to control the ELE output voltage V_{ELE} to synchronously follow the IUT output voltage V_{IUT} as in the I_{REF} = I_{IUT} case, except that the ELE rising edge (1r) is delayed by the rising edge time delay with respect to its corresponding IUT rising edge (2r). The delayed ELE rising edge (1r) is occurring after the comparison by the control unit (6) yielding the result I_{REF} > I_{IUT}, and preferably is a firstly occurring ELE rising edge (1r) after the comparison by the control unit (6). In the present context, the corresponding ELE rising edge (1r) is the ELE rising edge that would occur synchronously with the IUT rising edge (2r) if the ELE was in the voltage following mode.

During the rising edge time delay between the ELE and IUT rising edges, the IUT output voltage thus takes an IUT voltage state with a higher voltage than the ELE voltage state taken by the ELE output voltage, the filter voltage V_{F} is positive and the IUT output current I_{IUT} increases. In this case, and in the example of the invention wherein the coupling filter (4) comprises only a series-connected inductor L_{F} and wherein a parasitic resistance R_{P} of the inductor L_{F} is negligible, V_{F} ≈ L_{F}*dI_{IUT}/dt and dI_{lUT}/dt > 0 since V_{F} is positive. In this case, the control unit (6) is preferably configured to delay the following ELE rising edge (1r) with respect to its corresponding IUT rising edge (2r) by a rising edge time delay of Δt = L_{F}*|I_{REF} - I_{IUT}|/|V_{ELE}-V_{IUT}|, wherein |I_{REF} - I_{IUT}| is the absolute value of the difference between the reference current and the measured IUT current, and wherein |V_{ELE}-V_{IUT}| is the absolute value of the difference between the ELE and IUT output voltages i.e., between the voltages associated to the ELE and IUT voltages states during the time delay Δt between the following ELE rising edge (1r) and its corresponding IUT rising edge (2r).

### I_{REF} lower than I_{IUT}

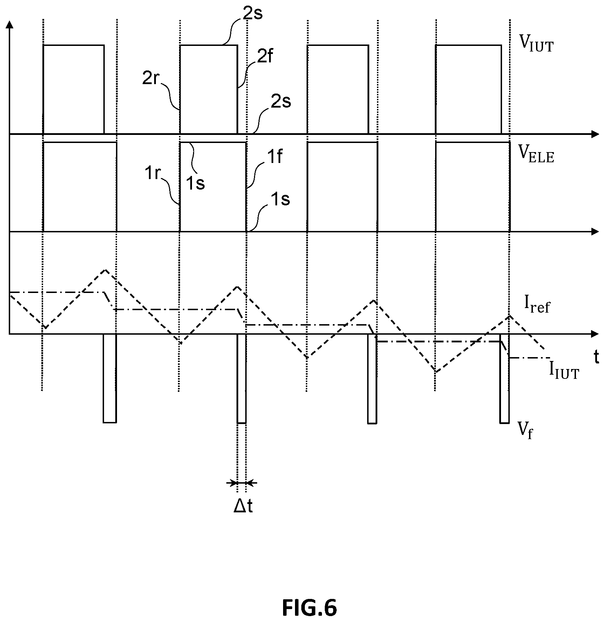

If I_{REF} is lower than I_{IUT}, the control unit (6) is configured to delay one of the following ELE falling edge (1f) with respect to its corresponding IUT falling edge (2f) by a falling edge time delay, as illustrated in Fig. 6. Preferably, the ELE (1) is configured to compare the reference current I_{REF} to the measured IUT output current I_{IUT} and to calculate the rising or falling edge time delay to be applied periodically at the third frequency F3. In the present context, the following ELE falling edges are the ELE falling edges occurring after the measured IUT output current is compared with the reference current and the falling edge time delay to be applied is calculated by the control unit (6). In the example of Fig. 6, the control unit (6) compares I_{REF} to I_{IUT} and calculates the falling edge time delay to be applied at the times Ti1, Ti2, Ti3, Ti4. Preferably, the control unit (6) is configured to delay the firstly occurring ELE falling edge (1f) with respect to its corresponding IUT falling edge (2f), as illustrated in Fig. 6, so that the IUT output current is rapidly adjusted closer to the reference current. Of course, the skilled person shall easily recognize that the voltage and current signals represented in Fig. 6 are idealized signals which do not restrict the scope of the invention. In real cases, these signals comprising V_{IUT} and V_{ELE} can comprise noise, ripple, and the IUT and ELE rising and falling edges have finite slopes, which is not represented in Fig. 6. Parasitic delays are also not represented in Fig. 6.

If I_{REF} is lower than I_{IUT}, the control unit (6) is thus preferably configured to control the ELE output voltage V_{ELE} to synchronously follow the IUT output voltage V_{IUT} as in the I_{REF} = I_{IUT} case, except that the ELE falling edge (1f) is delayed with respect to its corresponding IUT falling edge (2r) by the falling edge time delay. The delayed ELE falling edge (1f) is occurring after the comparison by the control unit (6) yielding the result I_{REF} < I_{IUT} During this falling edge time delay between the ELE and IUT falling edges, the IUT output voltage thus takes an IUT voltage state with a lower voltage than the ELE voltage state taken by the ELE output voltage, the filter voltage V_{F} is negative, and the IUT output current I_{IUT} decreases. In this case, and in the example of the invention wherein the coupling filter (4) comprises only a series-connected inductor L_{F} and wherein a parasitic resistance R_{P} of the inductor L_{F} is negligible, V_{F} ≈ L_{F}*dI_{IUT}/dt and dI_{IUT}/dt < 0 since V_{F} is negative. In this case, the control unit (6) is preferably configured to delay the following ELE falling edge (1f) with respect to its corresponding IUT falling edge (2f) by the falling edge time delay of Δt = L_{F}*|I_{REF} - I_{IUT}|/|V_{ELE}-V_{IUT}|, wherein |I_{REF} - I_{IUT}| is the absolute value of the difference between the reference current and the measured IUT current, and wherein |V_{ELE}-V_{IUT}| is the absolute value of the difference between the ELE and IUT output voltages i.e., between the voltages associated to the ELE and IUT voltages states during the time falling edge time delay Δt between the following ELE falling edge (1f) and its corresponding IUT falling edge (2f).

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise.

While the invention has been described hereinabove with reference to specific embodiments, the skilled person will appreciate that various modifications and different combinations of disclosed features are possible without departing from the scope of the invention, as defined by the appended claims.

### References

| | |
|---|---|
| 1 | Electrical Load Emulator (ELE) |
| 1r | Rising edge of the ELE output voltage |
| 1f | Falling edge of the ELE output voltage |
| 1s | ELE voltage state of the ELE output voltage |
| 2 | Inverter Under Test (IUT) |
| 2r | Rising edge of the IUT output voltage |
| 2f | Falling edge of the IUT output voltage |
| 2s | IUT voltage state of the IUT output voltage |
| 3 | Current sensor |
| 4 | Coupling filter |
| 5 | Voltage sensing unit |
| 6 | Control unit |
| 7 | ELE inverter |
| 7l | ELE inverter phase leg |
| 7s | ELE switching units |
| 8 | DC power source |
| 9 | ELE output terminal |
| 10 | IUT output terminal |

## Claims

1. An electrical load emulator, ELE (1), for an inverter under test, IUT (2), wherein an IUT output voltage V_{IUT} at an IUT output terminal is configured to take a plurality of IUT voltage states, separated by IUT rising and falling edges, and wherein an ELE output voltage at an ELE output terminal is configured to take a plurality of ELE voltage states, separated by ELE rising and falling edges, and wherein to each IUT voltage state corresponds at least one ELE voltage state, and wherein the ELE comprises:
- a current sensor (3) configured to measure an IUT output current I_{IUT},
- a coupling filter (4) for connecting the ELE to the IUT,
- a voltage sensing unit (5) configured to sense the IUT output voltage V_{IUT},
- a control unit (6), wherein the electrical load emulator, ELE, is **characterised in that** the control unit is configured to:
∘ determine a reference current I_{REF} corresponding to an emulated electrical load based on the sensed IUT output voltage V_{IUT},
∘ compare the reference current I_{REF} to the measured IUT output current I_{IUT},
- if I_{REF} is equal to I_{IUT}, the control unit (6) is configured to control the ELE output voltage to synchronously follow the IUT output voltage, such that each of the IUT rising and/or falling edge between two subsequent IUT voltage states is followed by a corresponding ELE rising and/or falling edge between two subsequent ELE voltage states, respectively,
- if I_{REF} is higher than I_{IUT}, the control unit (6) is configured to delay the following ELE rising edge with respect to its corresponding IUT rising edge by a rising edge time delay,
- if I_{REF} is lower than I_{IUT}, the control unit (6) is configured to delay the following ELE falling edge with respect to its corresponding IUT falling edge by a falling edge time delay.

2. ELE according to claim 1, wherein each phase of the coupling filter (4) comprises at least a series-connected inductor L_{F}, preferably only the series-connected inductor L_{F}.

3. ELE according to claim 1 or 2, comprising an ELE inverter (7) which has a two-level topology or multi-level topology.

4. ELE according to any of the preceding claims, wherein the ELE inverter (7) is configured to be supplied by a DC power source (8) which is shared with the IUT (2).

5. ELE according to any of the preceding claims, wherein the control unit (6) is configured to:
- determine the reference current I_{REF} corresponding to the emulated electrical load based on the measured IUT output voltage V_{IUT},
- compare the reference current I_{REF} to the measured IUT output current I_{IUT}, and calculate the rising or falling edge time delay,
asynchronously with the IUT output voltage V_{IUT}.

6. ELE according to any of the preceding claims, wherein the control unit (6) is configured to:
- determine the reference current I_{REF} corresponding to the emulated electrical load based on the measured IUT output voltage V_{IUT} periodically at a second frequency F2, wherein the second frequency F2 is preferably comprised between a third of the switching frequency of the IUT and 300 MHz, preferably between the switching frequency of the IUT and 100 MHz, preferably between 2 and 50 MHz, preferably between 3 and 10 MHz,
- compare the reference current I_{REF} to the measured IUT output current I_{IUT} and calculate the rising or falling edge time delay periodically and at a third frequency F3, wherein the third frequency F3 is preferably lower than or equal to the second frequency F2, and wherein the third frequency F3 is preferably comprised between 100 Hz and 100 MHz, preferably between 1 kHz and 20 MHz, preferably between 10 kHz and 10 MHz, preferably between 1 and 5 MHz.

7. Method for controlling an electrical load emulator, ELE (1), according to any of the previous claims, for testing an inverter under test, IUT (2), wherein an IUT output voltage V_{IUT} at an IUT output terminal is configured to take a plurality of IUT voltage states, separated by IUT rising and falling edges, the method comprising :
- sensing the IUT output voltage V_{IUT} at the IUT output terminal,
- determining a reference current I_{REF} corresponding to an emulated electrical load based on the sensed IUT output voltage V_{IUT},
- measuring an IUT output current I_{IUT},
- comparing the reference current I_{REF} to the measured IUT output current I_{IUT},
- if I_{REF} is equal to I_{IUT}, controlling the ELE output voltage to synchronously follow the IUT output voltage V_{IUT}, such that each IUT rising and/or falling edge between two subsequent IUT voltage states is followed by a corresponding ELE rising and/or falling edge between two subsequent ELE voltage states, respectively,
- if I_{REF} is higher than I_{IUT}, delaying the following ELE rising edge with respect to its corresponding IUT rising edge by a rising edge time delay,
- if I_{REF} is lower than I_{IUT}, delaying the following ELE falling edge with respect to its corresponding IUT falling edge by a falling edge time delay.

8. A programmable hardware for controlling an electrical load emulator, ELE, for testing an inverter under test, IUT, configured for making an ELE perform the method according to claim 7, wherein the programmable hardware is a programmable logic device such as FPGA, EPROM, or a microcontroller.

## Patentansprüche

1. Elektrischer Lastemulator, ELE (1), für einen zu testenden Wechselrichter, IUT (2), wobei eine IUT-Ausgangsspannung V_{IUT} an einem IUT-Ausgangsanschluss dazu eingerichtet ist, eine Vielzahl von IUT-Spannungszuständen einzunehmen, die durch IUT-Anstiegs- und Abfallflanken getrennt sind, und wobei eine ELE-Ausgangsspannung an einem ELE-Ausgangsanschluss dazu eingerichtet ist, eine Vielzahl von ELE-Spannungszuständen einzunehmen, die durch ELE-Anstiegs- und Abfallflanken getrennt sind, und wobei jedem IUT-Spannungszustand mindestens ein ELE-Spannungszustand entspricht, wobei der ELE umfasst:
- einen Stromsensor (3), der dazu eingerichtet ist, einen IUT-Ausgangsstrom I_{IUT} zu messen,
- ein Kopplungsfilter (4) zum Anschließen des ELE an den IUT,
- eine Spannungserfassungseinheit (5), die dazu eingerichtet ist, die IUT-Ausgangsspannung V_{IUT} zu erfassen,
- eine Steuereinheit (6), wobei der elektrische Lastemulator, ELE, **dadurch gekennzeichnet ist, dass** die Steuereinheit dazu eingerichtet ist:
∘ anhand der erfassten IUT-Ausgangsspannung V_{IUT} einen Referenzstrom I_{REF} zu bestimmen, der einer emulierten elektrischen Last entspricht,
∘ den Referenzstrom I_{REF} mit dem gemessenen IUT-Ausgangsstrom I_{IUT} zu vergleichen,
- wenn I_{REF} gleich I_{IUT} ist, ist die Steuereinheit (6) dazu eingerichtet, die ELE-Ausgangsspannung so zu steuern, dass sie der IUT-Ausgangsspannung synchron folgt, so dass jeder IUT-Anstiegs- und/oder Abfallflanke zwischen zwei aufeinanderfolgenden IUT-Spannungszuständen jeweils eine entsprechende ELE-Anstiegs- und/oder Abfallflanke zwischen zwei aufeinanderfolgenden ELE-Spannungszuständen folgt,
- wenn I_{REF} größer ist als I_{IUT}, ist die Steuereinheit (6) dazu eingerichtet, die folgende ELE-Anstiegsflanke in Bezug auf die ihr entsprechende IUT-Anstiegsflanke um eine Anstiegsflankenverzögerungszeit zu verzögern,
- wenn I_{REF} kleiner als I_{IUT} ist, ist die Steuereinheit (6) dazu eingerichtet, die folgende ELE-Abfallflanke in Bezug auf die ihr entsprechende IUT-Abfallflanke um eine Abfallflankenverzögerungszeit zu verzögern.

2. ELE nach Anspruch 1, wobei jede Phase des Kopplungsfilters (4) mindestens einen in Reihe geschalteten Induktor L_{F} umfasst, vorzugsweise nur den in Reihe geschalteten Induktor L_{F}.

3. ELE nach Anspruch 1 oder 2, umfassend einen ELE-Wechselrichter (7), der eine Zweistufen-Topologie oder Mehrstufen-Topologie aufweist.

4. ELE nach einem der vorhergehenden Ansprüche, wobei der ELE-Wechselrichter (7) dazu eingerichtet ist, von einer Gleichstromquelle (8) versorgt zu werden, die mit dem IUT (2) geteilt wird.

5. ELE nach einem der vorhergehenden Ansprüche, wobei die Steuereinheit (6) dazu eingerichtet ist:
- anhand der gemessenen IUT-Ausgangsspannung V_{IUT} den Referenzstrom I_{REF} zu bestimmen, der der emulierten elektrischen Last entspricht,
- den Referenzstrom I_{REF} mit dem gemessenen IUT-Ausgangsstrom I_{IUT} zu vergleichen und die Anstiegs- oder Abfallflankenverzögerungszeit zu berechnen,
asynchron mit der IUT-Ausgangsspannung V_{IUT}.

6. ELE nach einem der vorhergehenden Ansprüche, wobei die Steuereinheit (6) dazu eingerichtet ist:
- anhand der gemessenen IUT-Ausgangsspannung V_{IUT} den der emulierten elektrischen Last entsprechenden Referenzstrom I_{REF} periodisch bei einer zweiten Frequenz F2 zu bestimmen, wobei die zweite Frequenz F2 vorzugsweise zwischen einem Drittel der Schaltfrequenz des IUT und 300 MHz, vorzugsweise zwischen der Schaltfrequenz des IUT und 100 MHz, vorzugsweise zwischen 2 und 50 MHz, vorzugsweise zwischen 3 und 10 MHz liegt,
- den Referenzstrom I_{REF} mit dem gemessenen IUT-Ausgangsstrom I_{IUT} zu vergleichen und die Anstiegs- oder Abfallflankenverzögerungszeit periodisch und bei einer dritten Frequenz F3 zu berechnen, wobei die dritte Frequenz F3 vorzugsweise niedriger oder gleich der zweiten Frequenz F2 ist, und wobei die dritte Frequenz F3 vorzugsweise zwischen 100 Hz und 100 MHz, vorzugsweise zwischen 1 kHz und 20 MHz, vorzugsweise zwischen 10 kHz und 10 MHz, vorzugsweise zwischen 1 und 5 MHz liegt.

7. Verfahren zur Steuerung eines elektrischen Lastemulators, ELE (1), nach einem der vorhergehenden Ansprüche, zum Testen eines zu testenden Wechselrichters, IUT (2), wobei eine IUT-Ausgangsspannung V_{IUT} an einem IUT-Ausgangsanschluss dazu eingerichtet ist, eine Vielzahl von IUT-Spannungszuständen einzunehmen, die durch IUT-Anstiegs- und Abfallflanken getrennt sind, wobei das Verfahren umfasst:
- Erfassen der IUT-Ausgangsspannung V_{IUT} am IUT-Ausgangsanschluss,
- Bestimmen eines Referenzstroms I_{REF}, der einer emulierten elektrischen Last entspricht, anhand der gemessenen IUT-Ausgangsspannung V_{IUT},
- Messen eines IUT-Ausgangsstroms I_{IUT},
- Vergleichen des Referenzstroms I_{REF} mit dem gemessenen IUT-Ausgangsstrom I_{IUT},
- wenn I_{REF} gleich I_{IUT} ist, Steuern der ELE-Ausgangsspannung, so dass sie der IUT-Ausgangsspannung V_{IUT} synchron folgt, so dass jeder IUT-Anstiegs- und/oder Abfallflanke zwischen zwei aufeinanderfolgenden IUT-Spannungszuständen jeweils eine entsprechende ELE-Anstiegs- und/oder Abfallflanke zwischen zwei aufeinanderfolgenden ELE-Spannungszuständen folgt,
- wenn I_{REF} größer als I_{IUT} ist, Verzögern der folgenden ELE-Anstiegsflanke in Bezug auf die ihr entsprechende IUT-Anstiegsflanke um eine Anstiegsflankenverzögerungszeit,
- wenn I_{REF} kleiner als I_{IUT} ist, Verzögern der folgenden ELE-Abfallflanke in Bezug auf die ihr entsprechende IUT-Abfallflanke um eine Abfallflankenverzögerungszeit.

8. Programmierbare Hardware zur Steuerung eines elektrischen Lastemulators, ELE, zum Testen eines zu testenden Wechselrichters, IUT, die dazu eingerichtet ist, die Ausführung eines Verfahrens nach Anspruch 7 durch einen ELE zu ermöglichen, wobei die programmierbare Hardware ein programmierbares Logikbauelement wie FPGA, EPROM oder ein Mikrocontroller ist.

## Revendications

1. Émulateur de charge électrique, ELE (1), pour un onduleur à tester, IUT (2), dans lequel une tension de sortie de l'IUT V_{IUT} à une borne de sortie de l'IUT est configurée pour prendre une pluralité d'états de tension de l'IUT, séparés par des fronts montants et descendants de l'IUT, et dans lequel une tension de sortie de l'ELE à une borne de sortie de l'ELE est configurée pour prendre une pluralité d'états de tension de l'ELE, séparés par des fronts montants et descendants de l'ELE, et dans lequel il correspond à chaque état de tension de l'IUT au moins un état de tension de l'ELE, et dans lequel l'ELE comprend :
- un capteur de courant (3) configuré pour mesurer un courant de sortie de l'IUT I_{IUT},
- un filtre de couplage (4) pour relier l'ELE à l'IUT,
- une unité de détection de tension (5) configurée pour détecter la tension de sortie de l'IUT V_{IUT},
- une unité de commande (6), l'émulateur de charge électrique, ELE, étant **caractérisé en ce que** l'unité de commande est configurée pour :
∘ déterminer un courant de référence I_{REF} correspondant à une charge électrique émulée sur la base de la tension de sortie de l'IUT V_{IUT} détectée,
∘ comparer le courant de référence I_{REF} au courant de sortie de l'IUT I_{IUT} mesuré,
- si I_{REF} est égal à I_{IUT}, l'unité de commande (6) est configurée pour commander la tension de sortie de l'ELE afin qu'elle suive de manière synchrone la tension de sortie de l'IUT, de sorte que chaque front montant et/ou descendant de l'IUT entre deux états de tension successifs de l'IUT soit respectivement suivi d'un front montant et/ou descendant correspondant de l'ELE entre deux états de tension successifs de l'ELE,
- si I_{REF} est supérieur à I_{IUT}, l'unité de commande (6) est configurée pour retarder le front montant suivant de l'ELE par rapport au front montant correspondant de l'IUT d'un temps de retard de front montant,
- si I_{REF} est inférieur à I_{IUT}, l'unité de commande (6) est configurée pour retarder le front descendant suivant de l'ELE par rapport au front descendant correspondant de l'IUT d'un temps de retard de front descendant.

2. ELE selon la revendication 1, dans lequel chaque phase du filtre de couplage (4) comprend au moins un inducteur L_{F} connecté en série, de préférence uniquement l'inducteur L_{F} connecté en série.

3. ELE selon la revendication 1 ou 2, comprenant un onduleur d'ELE (7) qui présente une topologie à deux niveaux ou multiniveau.

4. ELE selon l'une quelconque des revendications précédentes, dans lequel l'onduleur de l'ELE (7) est configuré pour être alimenté par une source de courant continu (8) qui est partagée avec l'IUT (2).

5. ELE selon l'une quelconque des revendications précédentes, dans lequel l'unité de commande (6) est configurée pour :
- déterminer le courant de référence I_{REF} correspondant à la charge électrique émulée sur la base de la tension de sortie de l'IUT V_{IUT} mesurée,
- comparer le courant de référence I_{REF} au courant de sortie de l'IUT I_{IUT} mesuré et calculer le temps de retard de front montant ou descendant,
de manière asynchrone avec la tension de sortie de l'IUT V_{IUT}.

6. ELE selon l'une quelconque des revendications précédentes, dans lequel l'unité de commande (6) est configurée pour :
- déterminer le courant de référence I_{REF} correspondant à la charge électrique émulée sur la base de la tension de sortie de l'IUT V_{IUT} mesurée périodiquement à une seconde fréquence F2, la seconde fréquence F2 étant de préférence comprise entre un tiers de la fréquence de commutation de l'IUT et 300 MHz, de préférence entre la fréquence de commutation de l'IUT et 100 MHz, de préférence entre 2 et 50 MHz, de préférence entre 3 et 10 MHz,
- comparer le courant de référence I_{REF} au courant de sortie de l'IUT I_{IUT} mesuré et calculer le temps de retard de front montant ou descendant périodiquement et à une troisième fréquence F3, la troisième fréquence F3 étant de préférence inférieure ou égale à la deuxième fréquence F2, et la troisième fréquence F3 étant de préférence comprise entre 100 Hz et 100 MHz, de préférence entre 1 kHz et 20 MHz, de préférence entre 10 kHz et 10 MHz, de préférence entre 1 et 5 MHz.

7. Procédé de commande d'un émulateur de charge électrique, ELE (1), selon l'une quelconque des revendications précédentes, pour tester un onduleur à tester, IUT (2), dans lequel une tension de sortie de l'IUT V_{IUT} à une borne de sortie de l'IUT est configurée pour prendre une pluralité d'états de tension de l'IUT, séparés par des fronts montants et descendants de l'IUT, le procédé comprenant :
- détecter la tension de sortie de l'IUT V_{IUT} à la borne de sortie IUT,
- déterminer un courant de référence I_{REF} correspondant à une charge électrique émulée sur la base de la tension de sortie de l'IUT V_{IUT} détectée,
- mesurer un courant de sortie de l'IUT I_{IUT},
- comparer le courant de référence I_{REF} au courant de sortie de l'IUT I_{IUT} mesuré,
- si I_{REF} est égal à I_{IUT}, commander la tension de sortie de l'ELE pour qu'elle suive de manière synchrone la tension de sortie de l'IUT V_{IUT}, de sorte que chaque front montant et/ou descendant de l'IUT entre deux états de tension IUT successifs soit respectivement suivi d'un front montant et/ou descendant correspondant de l'ELE entre deux états de tension successifs de l'ELE,
- si I_{REF} est supérieur à I_{IUT}, retarder le front montant suivant de l'ELE par rapport au front montant correspondant de l'IUT d'un temps de retard de front montant,
- si I_{REF} est inférieur à I_{IUT}, retarder le front descendant suivant de l'ELE par rapport au front descendant correspondant de l'IUT d'un temps de retard de front descendant.

8. Matériel programmable pour contrôler un émulateur de charge électrique, ELE, pour tester un onduleur à tester, IUT, configuré pour faire exécuter à un ELE la méthode selon la revendication 7, le matériel programmable étant un dispositif logique programmable tel que FPGA, EPROM, ou un microcontrôleur.
